# FASCICULE DE BREVET EUROPEEN

(11) **EP 2 371 057 B1**
(45) Date de publication et mention de la délivrance du brevet: **05.09.2012**
(21) Numéro de dépôt: 09796687.3
(22) Date de dépôt: 15.12.2009
(51) Int. Cl.: H03D 7/14, H03D 7/16

(54) **MELANGEUR A TRANSISTOR ET ECHANTILLONNEUR BLOQUEUR**
TRANSISTORMISCHER UND SAMPLE-AND-HOLD-SCHALTUNG
TRANSISITOR MIXER AND SAMPLE AND HOLD CIRCUIT

(30) Priorité: 16.12.2008 FR 0807066
(43) Date de publication de la demande: 05.10.2011
(73) Titulaire: THALES, 92200 Neuilly-sur-Seine (FR)
(72) Inventeur: FROMENT, Laura, F-19100 Brive (FR); POUMIER, Christian, F-19410 Vigeois (FR)
(74) Mandataire: Dudouit, Isabelle
(86) Numéro de dépôt international: PCT/EP2009/067192
(87) Numéro de publication internationale: WO 2010/069956

(56) Documents cités:
- EP-A- 1 926 208
- US-A1- 2007 218 850
- US-B1- 6 230 000

## Description

L'objet de la présente invention concerne un mélangeur à transistor et échantillonneur bloqueur; le dispositif permet la transposition en bande de base d'un signal de la bande radio fréquence RF.

Elle est utilisée, par exemple, dans la radio analogique qui demande une démodulation directe avec un échantillonneur bloqueur.

Elle s'applique notamment dans les dispositifs à haute dynamique, c'est-à-dire pour des signaux dont la valeur du rapport entre le signal de sortie du dispositif et le signal présent à l'entrée du dispositif est élevé. La dynamique se situe par exemple entre 3 dBm pour le signal le plus fort et -160 dBm pour le plus faible dans 1 Hz de bande passante. Le gain du dispositif de mélange et de l'interface développée selon l'invention est de l'ordre de 40 dB. Ceci permet de compenser le facteur de bruit des convertisseurs analogique numérique se trouvant en sortie du dispositif.

L'invention s'applique, par exemple, pour des récepteurs recevant des signaux analogiques nécessitant une très grande dynamique de fonctionnement lors de la présence en même temps de deux signaux, le signal utile en limite de sensibilité du récepteur (c'est-à-dire que le récepteur parvient à le percevoir malgré sa faible amplitude, par exemple) l'autre étant un signal parasite ayant un fort niveau et pouvant rendre non visible le signal de faible amplitude. Le signal parasite étant connu sous le terme de signal brouilleur par rapport au signal utile.

L'invention concerne notamment les récepteurs de radio navigation et radio communication.

Dans la suite de la description, le mot « brouilleur » est utilisé pour des signaux qui perturbent le signal reçu et qui gênent voir empêchent l'accès au signal utile. Le niveau du signal de brouillage peut être supérieur à 3 dBm.

Dans le domaine technique précité, parmi les problèmes généralement rencontrés, les plus connus sont la linéarité et le facteur du bruit dans un dispositif de mélange direct. A l'heure actuelle, il est aussi souhaité d'avoir une simplification de l'architecture globale d'un récepteur.

L'art antérieur décrit différents dispositifs cherchant à résoudre ces problèmes. Par exemple, le brevet US 6 230 000 décrit un mélangeur à commutation. S'il s'avère performant, ce dispositif ne parvient toutefois pas à assurer une bonne réception des signaux pour des applications à dynamique élevée, une valeur pouvant être définie de la manière suivante : >3 dbm pour le signal fort et -127 dbm pour le signal faible dans 5 kHz de bande passante et offre une linéarité qui se révèle insuffisante pour certaines applications, notamment, pour des utilisations dans des environnements où des brouilleurs sont présents. Ainsi, le dispositif décrit dans ce brevet US 6 230 000 limite la bande passante à 100 KHz, avec un facteur de bruit de 12 dB ainsi qu'une fréquence de fonctionnement limitée à 100 MHz. Un autre dispositif mélangeur à transistors est connu par exemple par le document EP 1 926 208 A.

Il est aussi connu de nombreuses architectures de mélangeur. Ces dernières ne présentent pas en général un niveau de dynamique suffisant pour des applications à haute dynamique.

L'objet de l'invention concerne un mélangeur à transistor et échantillonneur bloqueur selon la revendication 1. Il repose sur une transposition en bande de base d'un signal RF avec un montage haute dynamique, faible facteur de bruit et dotée d'une bonne sensibilité.

Les signaux transmis sur le premier amplificateur différentiel et sur le deuxième amplificateur différentiel sont par exemple répartis de la manière suivante : le signal déphasé de 0° est transmis à une première entrée d'un premier amplificateur différentiel et le signal déphasé de 180° se trouve sur une deuxième entrée du même amplificateur différentiel U1, le signal déphasé de 90° est relié à une première entrée d'un deuxième amplificateur différentiel U2 et le signal déphasé de 270° est relié à une deuxième entrée du même amplificateur différentiel.

Les caractéristiques des circuits RC du premier étage de filtrage peuvent être adaptées pour obtenir une pente de 6dB par octave.

Les caractéristiques des composants Lᵢ, Cᵢ peuvent être adaptées pour obtenir une pente de filtrage de 12 dB par octave.

Les caractéristiques des composants des ponts LC du troisième étage de filtrage sont, par exemple, adaptées pour obtenir une pente de filtrage de 12 dB par octave.

Selon un mode de réalisation, la structure LiCi respecte une structure butterworth.

L'invention peut être utilisé pour des signaux ayant une dynamique comprise entre 3dBm pour le signal le plus fort et -160 dBm pour le faible dans 1 Hz de bande passante ou dans une bande passante de 5 KHz de + 3dBm pour le signal fort et -123 dBm pour le signal faible.

D'autres caractéristiques et avantages du dispositif selon l'invention apparaîtront mieux à la lecture de la description qui suit d'un exemple de réalisation donné à titre illustratif et nullement limitatif annexé de la figure unique 1 qui représente un exemple d'architecture d'un mélangeur direct à échantillonneur bloqueur selon l'invention.

L'exemple donné pour mieux illustrer le dispositif selon l'invention vise des signaux dont la dynamique est comprise entre 3dBm pour le signal le plus fort et -160 dBm pour le faible dans 1 Hz de bande passante ou dans une bande passante de 5 KHz de + 3dBm pour le signal fort et -123 dBm pour le signal faible. Ces fourchettes ne sont données qu'à titre illustratif et nullement limitatif pour mieux faire comprendre l'invention.

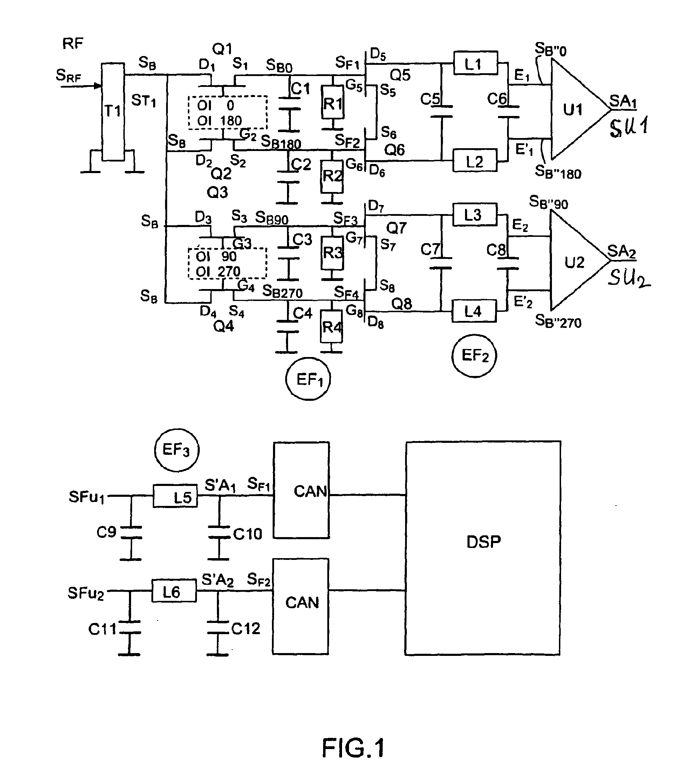

Sur la figure 1 de la planche unique est représenté un exemple d'architecture d'un mélangeur direct avec échantillonneur bloqueur selon l'invention.

Le sigal radio fréquence S_{RF}, ayant une fréquence F_{RF} est composé du signal utile Su et d'éventuels signaux de brouillage qui peuvent gêner son exploitation. Ce signal RF radiofréquencepasse à travers un dispositif de transposition en fréquence T₁ ayant notamment pour fonction d'exécuter une transposition en bande de base sur le signal d'entrée. Le signal transposé S_{B} est ensuite transmis simultanément à 4 transistors Q1, Q2, Q3 et Q4 fonctionnant en commutation. Un signal oscillateur local de fréquence F_{OL} est appliqué sur les grilles G1, G2, G3 et G4 des transistors. Chacun des transistors Q1, Q2, Q3 et Q4 est ainsi soumis à une fréquence d'oscillateur identique mais avec des phases différentes. Sur le premier transistor Q1, la phase est de 0°, sur le deuxième transistor Q2 de 180°, sur le troisième transistor Q3 de 90° et sur le quatrième transistor Q4 de 270°. Ainsi en sortie du transistor Q1, le signal S_{B0} a un déphasage de 0°, ce signal correspond au signal RF mélangé au signal de l'oscillateur local S_{OL} déphasé de 0°. En sortie de Q2, le signal S_{B180} correspond au signal transposé SB déphasé de 180°. En sortie de Q3, le signal obtenu correspond au signal de base transposé déphasé de 90°. En sortie de Q4 le signal SB₂₇₀ est déphasé de 270° par rapport au signal d'entrée S_{B}. La valeur de fréquence F_{OL} de l'oscillateur local OL est choisie voisine ou égale à celle du signal RF à transposer afin que la bande de modulation transposée reste dans la bande de base du filtrage BF réalisé par les filtres détaillés ci-après. Ces déphasages obtenus en injectant une fréquence F_{OL} permettent de ne conserver que la partie basse du spectre du signal RF.

La sortie S1, S2, S3 et S4 de chacun des transistors respectivement Q1, Q2, Q3 et Q4 est chargée par un réseau RiCi, notés R1C1, R2C2, R3C3 et R4C4. Le rôle de ce réseau est notamment de charger le condensateur par une tension résultante de la multiplication entre chacun des signaux issus des différents filtres et le signal F_{OL}. Cela correspond à l'enveloppe du signal résultant. Les condensateurs C1, C2. C3, C4 sont chargés par la résistance série présentée par le transistor lorsqu'il est conducteur et la décharge est réalisée dans les résistances R1, R2, R3 et R4 respectivement.

Les signaux S_{B0}, S_{B180}, S_{B90} et S_{B270} sont individuellement transmis à un système de mémorisation par condensateur constitué chacun d'une capacité C1, C2, C3, C4 mise en parallèle avec une résistance respectivement R1, R2, R3, R4, chaque résistance étant reliée à une masse M. Le signal bande de base est ainsi filtré, ce qui constitue un premier niveau de filtrage EF1 avec une pente par exemple de 6dB par octave.

Les signaux issus de ces quatre filtres F1 = R1C1, F2=R2C2, F3=R3C3 et F4=R4C4 notés respectivement SF1, SF2, SF3 et SF4 sont envoyés sur la grille G5, G6, G7 et G8 d'un transistor, respectivement sur les transistors Q5, Q6, Q7 et Q8. Ces transistors sont reliés par paire de la manière suivante : la source S5 du transistor Q5 est reliée à la source S6 du transistor Q6, les deux sources S7 et S8 des transistors Q7 et Q8 sont reliées ensemble. Ceci peut être vu comme un groupe de deux transistors qui vont être disposés en amont d'un deuxième étage de filtrage EF2 et des amplificateurs différentiels détaillés ci-après.

Le fonctionnement des transistors est équivalent à celui de commutateurs qui conduisent dès que la tension de commande Vci appliquée sur la grille Gi du transistor Qi est supérieure à la tension de la source Vsi.

Deux transistors Q5, Q6 et Q7, Q8 conduisent en même temps afin d'obtenir une tension continue identique ou sensiblement identique sur les deux sorties D5, D6, et D7 et D8 et ainsi d'éliminer la tension continue résiduelle par l'utilisation d'un amplificateur différentiel placé après (diminution des pollutions du mode commun).

Les signaux S'F1, S'F2, S'F3 et S'F4 issus des transistors Q5, Q6 et Q7, Q8 sont transmis à un deuxième étage de filtrage EF2 constitué de capacités Cᵢ et d'inductances Lᵢ dont les valeurs caractéristiques ainsi que l'agencement permettent d'avoir un filtrage complémentaire de 12 dB par octave, par exemple. Le filtre constitué par les composants L1, C5, L2, C6 est, par exemple, un filtre de structure butterworth qui permet de limiter le temps de groupe du filtre tous en offrant une bonne réjection.

En sortie de ce deuxième étape de filtrage, les signaux déphasés de 180° et filtrés S_{B}"0, S_{B}"₁₈₀, S_{B"90} et S_{B"270} sont transmis chacun sur une entrée Ei d'un amplificateur différentiel U1 et U2. U1 reçoit sur ses deux entrées E1 et E'1 les signaux filtrés et déphasés S_{B"0}, S_{B"180} et U2 reçoit sur ses deux entrées E2 et E'2 les signaux filtrés et déphasés S_{B"90}, S_{B"270}. En sortie SU1 de U1 et SU2 de U2, les deux signaux SA1 et SFA2 sont déphasés de 90°.

Les signaux amplifiés SA1 et SA2 sont ensuite envoyés sur un troisième étage de filtrage EF3 composé d'un pont constitué lui-même de deux capacités disposées en parallèle et d'une inductance. Ce troisième étage de filtrage permet d'obtenir un filtrage complémentaire de 12 dB par octave.

Le déphasage de 90° entre les signaux SA1 et SA2 permet un traitement complexe des données constituant le signal. Les signaux filtrés S'A1 et S'A2 sont ensuite transmis à un convertisseur analogique numérique CAN₁, CAN₂ avant d'être transmis à un dispositif de traitement de signal de type DSP par exemple abréviation anglo-saxonne connue pour Digital Signal Processing.

L'invention utilisant un montage à haute dynamique et faible facteur de bruit pour transposer le signal RF reçu au niveau d'un récepteur en bande de base offre notamment les avantages suivants :
- Elle permet de palier les limitations de dynamique des convertisseurs analogique numérique en ajoutant des filtrages répartis à différents endroits de la chaîne et un complément d'amplification afin de limiter l'impact de facteur de bruit des convertisseurs analogique numériques.
- Un tel schéma peut être utilisé en sous-harmonique. Dans ce cas, il y a une perte de signal en fonction du niveau d'harmonique choisi.

Le pré-filtrage permet de ne recevoir quel l'harmonique qui est requise. Le montage selon l'invention possède une propriété de recevoir un signal en sous échantillonnage c'est à dire que tout signal en relation sous harmonique avec le signal d'entrée pourra être transposé en bande de base avec une atténuation en 20LOG (du rang harmonique) par rapport au signal à fréquence fondamentale d'ou la nécessité de faire précéder le montage par un filtre.

La bande de couverture obtenue est très large. En effet, le montage de l'invention n'est limité en fréquence que par les capacités parasites et les temps de montée et descente des transistors utilisés en commutation donc il n'y a pas de limitation vers les fréquences basse. La limitation vers les fréquences hautes se situe avec les technologies actuelles tous en ayant la dynamique requise au environ de 600 Mhz et voisine de 2 GHz avec une perte de dynamique d'environ 15 dB sur plusieurs octave avec pré-filtrage.

L'inter-modulation est améliorée par rapport aux montages précédents par un gain uniquement en bande de base avec des fonctions à contre réaction, ce qui confère au montage une « haute linéarité ».

## Revendications

1. Dispositif mélangeur à transistor et échantillonneur bloqueur pour des signaux à dynamique élevée comportant en combinaison au moins les éléments suivants :
o un dispositif (T1) adapté à transposer en bande de base un signal radio-fréquence (SRF), ledit signal radio-fréquence, RF, étant composé d'un signal utile Su et de signaux de brouillage,
o la sortie (ST1) du dispositif de transposition est reliée à quatre transistors (Q1, Q2, Q3 et Q4)au niveau du drain (D1, D2, D3 et D4), la grille (G1, G2, G3 et G4) de chacun des transistors (Q1, Q2, Q3 et Q4) est reliée à une source (O1) délivrant une fréquence d'oscillateur sensiblement identique sur chaque transistor avec des phases différentes distribuées de la manière suivante : déphasage 0° sur la grille du premier transistor (Q1), déphasage de 180° sur la grille du deuxième transistor (Q2), déphasage de 90° sur la grille du troisième transistor et déphasage de 270° sur la grille du quatrième transistor (Q4), la valeur de fréquence de l'oscillateur étant proche de celle du signal radio-fréquence à transposer,
o chaque source (S1, S2, S3 et S4) des quatre transistors (Q1, Q2, Q3 et Q4) est reliée à un premier étage de filtrage (EF1) constitué de plusieurs réseaux RiCi, ayant des caractéristiques adaptées à filtrer le signal issu de la sortie des transistors,
o le premier étage de filtrage (EF1) possède quatre sorties, chacune de ces sorties est reliée à la grille (G5, G6, G7 et G8) d'un transistor additionnel respectif (Q5, Q6, Q7 et Q8) appartenant à un deuxième étage de filtrage (EF2), les transistors additionnels sont couplés deux par deux au niveau de leurs sources (5, S6, S7, S8), une source d'un premier transistor d'une paire étant reliée à la sa source d'un deuxième transistor,
o la sortie de chaque transistor additionnel (Q5, Q6, Q7 et Q8) est chargée par un circuit LiCi compris dans le deuxième étage de filtrage (EF2),
o deux sorties du deuxième étage de filtrage (EF2) dont les signaux sont déphasés de 180° sont reliées aux deux entrées d'un premier amplificateur différentiel (U1) et d'un deuxième amplificateur différentiel (U2),
o la sortie (SU1) du premier amplificateur différentiel est reliée à un troisième étage de filtrage et la sortie (SU2) du deuxième amplificateur différentiel est reliée à un troisième étage de filtrage (EF3) constitué de deux ponts LC,
o les deux signaux filtrés par le troisiéme étage de filtrage (EF3) sont ensuite transmis respectivement à un convertisseur analogique numérique (CAN₁, CAN₂).

2. Dispositif selon la revendication 1 **caractérisé en ce que** la répartition des signaux transmis sur le premier amplificateur différentiel et sur le deuxième amplificateur différentiel est de la forme suivante : le signal déphasé de 0° est relié à une première entrée au premier amplificateur différentiel et le signal déphasé de 180° est relié à une deuxième entrée du même premier amplificateur différentiel (U1), le signal déphasé de 90° est relié à une première entrée du deuxième amplificateur différentiel (U2) et le signal déphasé de 270° est relié à une deuxième entrée du même deuxième amplificateur différentiel.

3. Dispositif selon la revendication 1 **caractérisé en ce que** les caractéristiques des réseaux RC du premier étage de filtrage sont adaptées pour obtenir une pente de 6dB par octave.

4. Dispositif selon l'une des revendications 1 ou 2 **caractérisé en ce que** les caractéristiques des composants Lᵢ, Cᵢ sont adaptées pour obtenir une pente de filtrage de 12 dB par octave.

5. Dispositif selon l'une des revendications 1 à 3 **caractérisé en ce que** les caractéristiques des composants des ponts LC du troisième étage de filtrage sont adaptées pour obtenir une pente de filtrage de 12 dB par octave.

6. Dispositif selon la revendication 5 **caractérisé en ce que** le circuit LiCi a une structure butterworth.

7. Utilisation du dispositif selon l'une des revendications 1 à 6 pour des signaux ayant une dynamique comprise entre 3dBm pour le signal le plus fort et -160 dBm pour le faible dans 1 Hz de bande passante ou dans une bande passante de 5 KHz de + 3dBm pour le signal fort et -123 dBm pour le signal faible.

## Claims

1. A transistor mixer and sample and hold circuit device for high dynamic range signals comprising in combination at least the following elements:
- a device (T1) designed to transpose a radio-frequency signal (SRF) into a baseband, said radio-frequency signal, RF, being composed of a useful signal Su and of jamming signals;
- the output (ST1) of the transposition device is connected to four transistors (Q1, Q2, Q3 and Q4) at the drain (D1, D2, D3 and D4), the gate (G1, G2, G3 and G4) of each of the transistors (Q1, Q2, Q3 and Q4) is connected to a source (OI) delivering an oscillator frequency that is essentially identical on each transistor with different phases that are distributed as follows: 0° dephasing on the gate of the first transistor (QI), 180° dephasing on the gate of the second transistor (Q2), 90° dephasing on the gate of the third transistor (Q3) and 270° dephasing on the gate of the fourth transistor (Q4), the frequency value of the oscillator being close to that of the radio-frequency signal to be transposed;
- each source (S1, S2, S3 and S4) of the four transistors (Q1, Q2, Q3 and Q4) is connected to a first filtering level (EF1) that is constituted by a plurality of networks RiCi having characteristics that are designed to filter the signal coming from the output of the transistors;
- the first filtering level (EF1) has four outputs, each of these outputs is connected to the gate (G5, G6, G7 and G8) of an additional respective transistor (Q5, Q6, Q7 and Q8) belonging to a second filtering level (EF2), the additional transistors are coupled in pairs at their sources (S5, S6, S7, S8), a source of a first transistor of a pair being connected to the source of a second transistor;
- the output of each additional transistor (Q5, Q6, Q7 and Q8) is charged by a circuit LiCi that is included in the second filtering level (EF2);
two outputs of the second filtering level (EF2) for which the signals are 180° dephased are connected to two inputs of a first differential amplifier (U1) and of a second differential amplifier (U2);
- the output (SU1) of the first differential amplifier is connected to a third filtering level and the output (SU2) of the second differential amplifier is connected to a third filtering level (EF3) that is constituted by two bridges LC;
the two signals filtered by the third filtering level (EF3) are subsequently respectively transmitted to a digital analogue converter (CAN_{1,} CAN₂).

2. The device according to claim 1, **characterised in that** the distribution of the signals transmitted on the first differential amplifier and on the second differential amplifier is of the following form: the 0° dephased signal is connected to a first input of the first differential amplifier and the 180° dephased signal is connected to a second input of the same first differential amplifier (U1), the 90° dephased signal is connected to a first input of the second differential amplifier (U2) and the 270° dephased signal is connected to a second input of the same second differential amplifier.

3. The device according to claim 1, **characterised in that** the characteristics of the RC networks of the first filtering level are designed to obtain a slope of 6dB per octave.

4. The device according to claim 1 or 2, **characterised in that** the characteristics of the components Lᵢ, Cᵢ are designed to obtain a filtering slope of 12 dB per octave.

5. The device according to any one of claims 1 to 3, **characterised in that** the characteristics of the components of the bridges LC of the third filtering level are designed to obtain a filtering slope of 12 dB per octave.

6. The device according to claim 5, **characterised in that** the circuit LiCi has a Butterworth structure.

7. The use of the device according to any one of claims 1 to 6 for signals having a dynamic range of between 3dBm for the strongest signal and -160 dBm for the weakest signal in 1Hz of passband or in a passband of 5 KHz of +3dBm for the strong signal and - 123 dBm for the weak signal.

## Patentansprüche

1. Transistormischer- und Sample-and-Hold-Schaltungsvorrichtung für Signale mit hoher Dynamik, die in Kombination mindestens die folgenden Elemente aufweist:
- eine Vorrichtung (T1), die angepasst ist, um ein Funkfrequenzsignal (SRF) in Basisband zu übertragen, wobei das Funkfrequenzsignal RF aus einem nützlichen Signal Su und Störsignalen zusammengesetzt ist,
- der Ausgang (ST1) der Übertragungsvorrichtung mit vier Transistoren (Q1, Q2, Q3 und Q4) auf Ebene des Drains (D1, D2, D3 und D4) verbunden ist, wobei das Gitter (G1, G2, G3 und G4) jedes Transistors (Q1, Q2, Q3 und Q4) mit einer Quelle (OI) verbunden ist, die eine Oszillatorfrequenz liefert, die auf jedem Transistor etwa identisch ist mit unterschiedlichen Phasen, die folgendermaßen verteilt sind: Phasenverschiebung 0° auf dem Gitter des ersten Transistors (Q1), Phasenverschiebung um 180° auf dem Gitter des zweiten Transistors (Q2), Phasenverschiebung um 90° auf dem Gitter des dritten Transistors und Phasenverschiebung um 270° auf dem Gitter des vierten Transistors (Q4), wobei der Frequenzwert des Oszillators nahe dem Wert des zu übertragenden Funkfrequenzsignals ist,
- jede Quelle (S1, S2, S3 und S4) der vier Transistoren (Q1, Q2, Q3 und Q4) mit einer ersten Filterstufe (EF1) verbunden ist, die von mehreren RiCi-Netzen gebildet wird mit Merkmalen, die geeignet sind, um das am Ausgang der Transistoren ausgegebene Signal zu filtern,
- die erste Filterstufe (EF1) vier Ausgänge besitzt, wobei jeder dieser Ausgänge mit dem Gitter (G5, G6, G7 und G8) eines jeweiligen zusätzlichen Transistors (Q5, Q6, Q7 und Q8) verbunden ist, der zu einer zweiten Filterstufe (EF2) gehört, wobei die zusätzlichen Transistoren auf Ebene ihrer Quellen (S5, S6, S7, S8) paarweise gekoppelt sind, wobei eine Quelle eines ersten Transistors eines Paars mit der Quelle eines zweiten Transistors verbunden ist,
- der Ausgang jedes zusätzlichen Transistors (Q5, Q6, Q7 und Q8) durch einen LiCi-Kreis versorgt wird, der in der zweiten Filterstufe (EF2) inbegriffen ist,
- zwei Ausgänge der zweiten Filterstufe (EF2), deren Signale um 180° phasenverschoben sind, mit zwei Eingängen eines ersten Differentialverstärkers (U1) und eines zweiten Differentialverstärkers (U2) verbunden sind,
- der Ausgang (SU1) des ersten Differentialverstärkers mit einer dritten Filterstufe verbunden ist und der Ausgang (SU2) des zweiten Differentialverstärkers mit einer dritten Filterstufe (EF3) verbunden ist, die von zwei LC-Brücken gebildet wird,
- die zwei von der dritten Filterstufe (EF3) gefilterten Signale danach an jeweils einen Analog-Digital-Umwandler (CAN₁, CAN₂) übertragen werden.

2. Vorrichtung nach Anspruch 1, **dadurch gekennzeichnet, dass** die Verteilung der auf den ersten Differentialverstärker und auf den zweiten Differentialverstärker übertragenen Signale folgender Form ist: das um 0° phasenverschobenen Signal ist mit einem ersten Eingang des ersten Differentialverstärkers verbunden und das um 180° phasenverschobene Signal ist mit einem zweiten Eingang desselben ersten Differentialverstärkers (U1) verbunden, das um 90° phasenverschobene Signal ist mit einem ersten Eingang des zweiten Differentialverstärkers (U2) verbunden und das um 270° phasenverschobene Signal ist mit einem zweiten Eingang desselben zweiten Differentialverstärkers verbunden.

3. Vorrichtung nach Anspruch 1, **dadurch gekennzeichnet, dass** die Merkmale der RC-Netze der ersten Filterstufe angepasst sind, um einen Abfall von 6 dB je Oktave zu erhalten.

4. Vorrichtung nach Anspruch 1 oder 2, **dadurch gekennzeichnet, dass** die Merkmale der Bauteile Lᵢ, Cᵢ angepasst sind, um einen Filterabfall von 12 dB je Oktave zu erhalten.

5. Vorrichtung nach einem der Ansprüche 1 bis 3, **dadurch gekennzeichnet, dass** die Merkmale der Bauteile der LC-Brücken der dritten Filterstufe angepasst sind, um einen Filterabfall von 12 dB je Oktave zu erhalten.

6. Vorrichtung nach Anspruch 5, **dadurch gekennzeichnet, dass** der LiCi-Kreis eine Butterworth-Struktur hat.

7. Verwendung der Vorrichtung nach einem der Ansprüche 1 bis 6 für Signale mit einer Dynamik zwischen inklusive 3 dBm für das stärkste Signal und -160 dBm für das schwache in 1 Hz Bandbreite oder in einer Bandbreite von 5 kHz von +3 dBm für das starke Signal und -123 dBm für das schwache Signal.
